# EUROPEAN PATENT APPLICATION

(11) **EP 4 014 768 A1**
(43) Date of publication of application: **22.06.2022**
(21) Application number: 20214059.6
(22) Date of filing: 15.12.2020
(51) Int. Cl.: A24F 40/60, H05K 1/03, H05K 1/02

(54) **MULTILAYER OPTOELECTRONIC ELEMENT FOR AN ELECTRICAL SMOKING DEVICE**

(71) Applicant: JT International SA, 1202 Geneva (CH)
(72) Inventor: POPOOLA, Olayiwola Olamiposi, Walton-on-Thames, KT12 2SJ (GB); Adair, Kyle, Lisburn, BT28 2 (GB); LOVEDAY, Peter, Woking, GU21 2EL (GB)
(74) Representative: Hannke, Christian

(57) **Abstract**

The invention relates to a housing (8) for an electrical smoking device (7) comprising a multilayer optoelectronic element (9). The multilayer optoelectronic element comprises the following layers (10) in the following order along the height direction of the multilayer optoelectronic element: a flexible printed circuit board (1), having at least a light emitting diode (2) and a capacitive sensor (3) arranged on its surface, a light guide layer (4), arranged on the light emitting diode carrying side of the flexible printed circuit board, and a cover layer (5), arranged on the light guide layer opposite to the flexible printed circuit board. The housing is characterized in that the cover layer is at least in some areas an outer surface (s0) of the electrical smoking device. The invention also relates to a method of manufacturing a housing for an electronical smoking device comprising multilayer optoelectronic element.

## Description

The present invention relates to a multilayer optoelectronic element comprised in a housing of an electrical smoking device. More particularly the invention relates to a method for manufacturing the housing for the electrical smoking device comprising the mentioned multilayer optoelectronic element.

Electrical smoking devices are known as electronic cigarettes, electro vaporizers or electronic nicotine delivery systems. All of them have a function to vaporize or atomize a liquid comprising nicotine into an aerosol, which is inhaled by a user. The electrical smoking systems comprise at least an energy supply device and a liquid storage container. For use in the dark, the electric smoking devices are often illuminated, wherein the energy supply device comprises for example a display or an LED. Such illuminated devices are already known and are mentioned in the following documents

From the document US9974338B2 is an electronic cigarette with an illuminated tip known. Furthermore, the document relates to a structure and a controller circuitry that illuminates the tip of the electronic cigarette based on draw strength.

The document US20200154779A1 relates to aerosol delivery devices such as smoking articles, and more particularly to aerosol delivery devices that may utilize electrically generated heat for the production of aerosol. The described device includes a light source comprising LED.

The document US9271525B2 relates to an electronic cigarette case, including a case body, a frame module disposed in the case body, a battery module, and a printed circuit board (PCB) module. Furthermore, the document describes the electronic cigarette case with a display unit comprising LED.

The abovementioned documents disclose electronic cigarettes with a light source, such as displays comprising LEDs. The current problem due to the mentioned devices is, that with each additional component inside and/or outside the energy supply device, the electrical smoking device becomes thicker, whereby the handiness of such devices suffers. It would be desirable to provide an electrical smoking device, which enables a handy housing for the user with at least a light source, more preferred with additional electronical functions. It would be particularly desirable if such an electrical smoking device could comprise a flexible printed circuit board inside the housing.

It is therefore the objective of the invention to provide a housing for an electrical smoking device, which comprises a light source. It is also the objective of the invention to provide a method for manufacturing such a housing.

The afore mentioned problems are solved by a housing for an electrical smoking device comprising a multilayer optoelectronic element. The multilayer optoelectronic element comprises the following layers in the following order along the height direction of the multilayer optoelectronic element: a flexible printed circuit board, having at least a light emitting diode and a capacitive sensor arranged on its surface, a light guide layer, arranged on the light emitting diode carrying side of the flexible printed circuit board, and a cover layer, arranged on the light guide layer opposite to the flexible printed circuit board. The housing is characterized in that the cover layer is at least in some areas an outer surface of the electrical smoking device.

Preferably, the electrical smoking device comprises at least the following components: a mouth piece, a container with at least one vaporizing substance and a vaporizer. The mouth piece is preferably in a fluid connection with the vaporizer and the container, wherein the vaporizer comprises a heater, which heats the vaporizing substance. Preferably, the components are installed inside the housing of the electrical smoking device at least in part.

Preferably, the housing of the electrical smoking device is ergonomically shaped. Such a shape is preferably a cuboid, a cylinder, an ellipsoid, a hexagonal prism, pentagonal prism or another handy shape. The cylindrical shape of the housing is particularly preferred. It is conceivable that the shape of the housing is identical to the classical cigarette, having identical radius. In this case the housing of the electrical smoking device is formed by the outer surface covering a cavity. Further, the housing comprises at least one area on the outer surface, which comprises at least one cutout. Preferably, the cover layer of the optoelectronic element is visible through the cutout at least in part viewed from the outside of the housing.

It is conceivable that the multilayer optoelectronic element comprises additional layers. In this case the optoelectronic element comprises a spacer layer and an adhesive layer additionally to the flexible printed circuit board, the light guide layer and the cover layer. The mentioned layers are preferably arranged in the following order along the height direction of the multilayer optoelectronic element: the flexible printed circuit board, the adhesive layer, the spacer layer, the light guide layer and the cover layer. It is also conceivable that the layer order is different to the mentioned. It is also possible that the multilayer optoelectronic element comprises more layers or other layers additionally to the flexible printed circuit board, the light guide layer and the cover layer.

Preferably, the thickness of the adhesive layer is in range of 0.1 mm and 0.01 mm, more preferred 0.05 mm. It is possible that the adhesive layer comprises acrylic as a carrier adhesive material. It is also possible that the adhesive layer comprises any other transparent adhesives. Preferably, the thickness of the spacer layer is in range of 1 mm and 0.1 mm, more preferred 0.4 mm. Preferably, the spacer layer comprises thermoplastic terpolymers such as acrylonitrile-butadiene-styrene copolymers or polycarbonate.

According to another embodiment, the housing for an electrical smoking device is characterized in that the total height of the multilayer optoelectronic element is ≤ 2 mm, preferably ≤ 1.7 mm, more preferably ≤ 1.5 mm, most preferably ≤ 1.3 mm.

In a preferred embodiment, the total height of the multilayer optoelectronic element is preferably 1.92 mm. In this case the thickness of the flexible printed circuit board is 0.57 mm, the thickness of the adhesive layer is 0.05 mm, the thickness of the spacer layer is 0.4 mm, the thickness of the light guide layer is 0.35 mm and the thickness of the cover layer is 0.55 mm. Due to the multilayered structure of the optoelectronic element, the total height might vary.

In case of three layers, the flexible printed circuit board, the light guide layer and the cover layer, the total height of the optoelectronic element is preferably 1.47 mm. Preferably, to adhere the layers to each other, a special frame in the housing holds them together. The frame is preferably arranged on the fringe areas of the cutout in the housing.

According to another embodiment, the housing for an electrical smoking device is characterized in that the light emitting diode is extending from the surface of a carrier layer of the flexible printed circuit board in the height direction, wherein the light emitting diode is preferably a side firing diode, emitting light in a direction perpendicular to the height direction, wherein the side firing diode is preferably arranged in a recess of the light guide layer.

It is conceivable that the flexible printed circuit board carries several light emitting diodes (LEDs). Depending on the requested service the used LEDs are preferably out of the following types: DIP LED (Dual-in-Line-Package), SMD LED (surface mounted devices), Low/Mid or High Power LED, COB LED (Chip on Board). Preferably, the height of the LED, extending from the surface of the carrier layer of the flexible printed circuit board in the height direction, depends on the used type. The typical height of the LEDs is preferably in range of 0.5 mm and 5 mm. The propagation direction of the light emitted by the LED is preferably in the plane of the light guide layer.

The light guide layer preferably comprises at least one recess for mounting a light emitting diode in this. Preferably a circumference of the recess of the light guide layer depends on the circumference of the used LED on the flexible printed circuit board. It is also possible that there is no recess in the light guide layer. In this case, the light guide layer is applied on the equipped flexible circuit board as a second cover layer. The light guide layer is then preferably applied on the flexible printed circuit board in a liquid form, wherein the light guide layer is hardened after the flexible printed circuit board has his end shape.

According to another embodiment, the housing for an electrical smoking device is characterized in that the flexible printed circuit board comprises a multilayer core comprising at least one polymer layer, and conductive circuit pattern affixed thereto, wherein the multilayer core preferably comprises ≥ 3, preferably ≥ 4, more preferably ≥ 5, most preferably ≥ 7 layer, from which an inner layer preferably comprises a polyimide.

Preferably, the flexible printed circuit board comprises a multilayer core as a common flexible carrier, which ensures a special flexibility of this. The multilayer core comprises at least one polyimide core, at least one conductive layer forming a circuit pattern, at least one adhesive layer and a coverlay as a base.

Also preferred, the flexible printed circuit board further comprises rigidizing zones, on which the electrical and/or electronical components are mounted. Depending on a size of an application, the rigidizing zones can be particularly small, so that the shape adaptation of a printed circuit board in the housing of the electrical smoking device is no longer a problem. Preferably, more than two rigidizing zones are formed on the flexible printed circuit board. More preferably, the number of the rigidizing zones is adapted to the necessary number of electrical and/or electronical components.

The electrical and/or electronic components are preferably soldered onto the rigidizing zones of a flexible printed circuit board. This is possible if the soldering points or soldermasks are prepared on the rigidizing zones. More preferably, the electrical and/or electronic components are pressed into the rigidizing zones of a flexible printed circuit board. It is also conceivable that the electrical and/or electronic components are glued to the rigidizing zones of the flexible printed circuit board with a conductive and heat-resistant adhesive. Such an adhesive comprises one or several components, which dry in a certain order when assembled or after other influences such as heat, cold or UV-rays.

It is conceivable that the first and the second rigidizing layer comprising the same rigidizing material are placed on an upper and lower side of the common flexible carrier. In this case the electrical and/or electronical components can be mounted on the both sides of the common flexible carrier. The rigidizing property is particularly noticeable at the points where the common flexible carrier is occupied on both sides.

According to another embodiment, the housing for an electrical smoking device is characterized in that a height of the flexible printed circuit board is ≤ 1 mm, preferably ≤ 0.5 mm, more preferably ≤ 0.25 mm, most preferably ≤ 0.15 mm.

The structure of the flexible printed circuit board can be described as follows. A common flexible carrier comprising a core layer forms a base of the flexible printed circuit board. Preferably the thickness of the base is in the range of 30 - 70 µm, more preferred 40 - 60 µm. A first conductive layer is preferably applied continuously over a complete upper side of the base. Preferably, the first conductive layer comprises copper. The thickness of the first conductive layer is preferably in range of 10 - 30 µm, more preferred 18 µm. A second conductive layer is preferably applied continuously over a complete lower side of the base. Preferably the thick-ness of the second conductive layer is similar to the first conductive layer. On the complete first and second conductive layer, preferably an adhesive layer is continuously applied. Preferably the thickness of the adhesive layer is in range of 15 - 40 µm, more preferred 25 µm. Preferably, on each of the conductive layers or on the adhesive layers a cover layer is continuously applied. The thick-ness of the cover layer is preferably in range of 10 - 15 µm, more preferred 12 µm. The layered structure described above preferably forms the common flexible carrier of the flexible printed circuit board. Preferably, the thickness of the common flexible carrier is in range of 100 - 200 µm, more preferred 160 - 195 µm. It is possible that separate layers or the entire flexible carrier vary in thickness. It is also conceivable that further layers are added to the common flexible carrier.

The following additional layers are applied on the upper and lower side of the flexible carrier to form at least two, preferably separate, rigidizing zones. The size of the rigidizing zones varies and depends on the used electrical and/or electronical components. Preferably, on the cover layers of the flexible carrier at least two glass fiber layers are applied. Preferably the thick-ness of one glass fiber layer is in range of 30 - 70 µm, more preferred 40 - 60 µm, most preferred 50 µm. A third conductive layer comprising copper is applied on the glass fiber layer of the upper side of the flexible carrier. Preferably the thickness of the third conductive layer is in range of 10 - 30 µm, more preferred 18 µm, most preferred similar to the thickness of the first and/or second conductive layer. A fourth conductive layer comprising copper is applied on the glass fiber layer of the lower side of the flexible carrier. Preferably, the thickness of the fourth conductive layer is in range of 10 - 30 µm, more preferred 18 µm, most preferred similar to the thickness of the first, second and/or third conductive layer. A plated copper is then applied on the third and fourth conductive layer. Preferably the thickness of the plated copper is in range of 15 - 40 µm, more preferred 25 µm. On the third and fourth conductive layer a soldermask layer is applied acting as a cover of the respective rigidizing zone. Preferably, the thickness of the soldermask layer is 10 µm. It is conceivable that the rigidizing zones are formed only on one side of the flexible carrier. The total thickness of the rigidizing zone comprising one conductive layer on one of the sides of the flexible carrier is preferably in range of 120 - 180 µm, more preferred 141 - 221 µm. It is possible that there are more than one conductive layers comprising copper in the rigidizing zone on each side. Preferably between the conductive layers the glass fiber layers are applied.

According to another embodiment, the housing for an electrical smoking device is characterized in that the light guide layer comprises a polymer, preferably a polyacrylate.

Preferably, the light guide layer further comprises a polymethylmethacrylate, polycarbonate, polystyrol, fluorinated acrylate or fluoropolymer. Preferably, the light guide layer has a high refractive index to allow light from the LED to be guided through the layer effected of total reflection. Preferably, the adjacent layers of the light guide layer have a lower refractive index than the light guide layer. Preferably, the difference in refractive indices, called numerical aperture, is in range of 0.1 and 0.3. Due to the fundamental material properties of the light guide layer, parts of the light are transmitted through the light guide layer into the adjacent layers. Preferably, the light guide layer comprising a main light direction and at least one secondary light transmission direction takes advantage of a loss of total reflexion and creates thereby a backlight effect. Preferably, the main light direction is parallel to the length direction, wherein the secondary light transmission directions are preferably at an angle to the main light transmission direction. The light guide layer has preferably a low weight and is insensitive to electromagnetic influences and temperature fluctuations.

According to another embodiment, the housing for an electrical smoking device is characterized in that the light guide layer comprises a recess into which an electric component mounted on the flexible printed circuit board extends.

It is conceivable that a capacitive sensor, which is mounted on the flexible printed circuit board, is not covered with a light guide layer. In this case the light guide layer comprises a recess comprising the capacitive sensor for mounting the same capacitive sensor. It is also possible, that there are more electric components mounted on the flexible printed circuit board, wherein the light guide layer comprises recesses for each electric component.

Preferably, the light guide layer is applied on the flexible printed circuit adjoining to at least one side firing diode. This allows to guide the light from the diode through the light guide layer, wherein the diode emits the light perpendicular to the height direction through the light guide layer. It is conceivable that additional components, preferably optical components, are arranged between the light guide layer and the diode.

Preferably, the light guide layer is applied on the flexible printed circuit board at least on one section, wherein the section is illuminated through the light guide layer. Preferably, the illuminated section serves as a backlight for printed graphics on the cover layer. Also preferred, the illuminated section serves as a backlight for a display.

According to another embodiment, the housing for an electrical smoking device is characterized in that a height of the light guide layer is ≥ 0.1 and ≤ 1 mm, preferably ≥ 0.2 and ≤ 0.8 mm, more preferably ≥ 0.3 and ≤ 0.7 mm, most preferably ≥ 0.4 and ≤ 0.6 mm. In a preferred embodiment, the height of the light guide layer is 0.35 mm.

According to another embodiment, the housing for an electrical smoking device is characterized in that the cover layer comprises a glass, preferably a tempered glass, wherein the cover layer provides means for detecting a changing capacity, preferably by means comprising a conductive layer within the cover layer. Preferably, the means for detecting the changing capacity comprise a sensor to detect and measure proximity, pressure, position, displacement force and/or acceleration. Also preferably, the cover layer comprises an input device, such as touchscreen.

According to another embodiment, the housing for an electrical smoking device is characterized in that a height of the cover layer is ≥ 0.1 and ≤ 1 mm, preferably ≥ 0.2 and ≤ 0.8 mm, more preferably ≥ 0.3 and ≤ 0.7 mm, most preferably ≥ 0.4 and ≤ 0.6 mm. In a preferred embodiment the cover layer comprises a hardened glass, wherein the height of the cover layer preferably is 0.55 mm. It is also possible that the cover layer comprises an alkali-aluminosilicate glass with a preferred height in range of 0.45 mm to 0.6 mm.

According to another embodiment, the housing for an electrical smoking device is characterized in that the cover layer has a Young's Modulus of ≥ 60 and ≤ 90 GPa, preferably ≥ 70 and ≤ 80 GPa, more preferably ≥ 72 and ≤ 78 GPa, most preferably ≥ 74 and ≤ 76 GPa and/or a shear modulus of ≥ 10 and ≤ 50 GPa, preferably ≥ 20 and ≤ 40 GPa, more preferably ≥ 25 and ≤ 35 GPa, most preferably ≥ 28 and ≤ 32 GPa.

According to another embodiment, the housing for an electrical smoking device is characterized in that the electrical smoking device comprises a mouthpiece arranged in an end portion of the electrical smoking device along its length direction, wherein the height of the multilayer optoelectronic element extends perpendicular with respect to the length direction of the electrical smoking device. The length direction of the electrical smoking device and the height direction of the multilayer optoelectronic element forms a Cartesian coordinate system with two axes and an origin at the point where the axes cross. The height of the electrical smoking device comprises the height of the multilayer optoelectronic element. Preferably the mouthpiece is mechanically connected to a cartridge with consumables, such as a liquid comprising tobacco.

According to another embodiment, the housing for an electrical smoking device is characterized in that the electrical smoking device comprises a mouthpiece arranged in an end portion of the electrical smoking device along its length direction, wherein the light guide layer extends over ≥ 10 %, preferably ≥ 20 %, more preferably ≥ 30 %, more preferably ≥ 40 %, most preferably ≥ 50 % of the length of the electrical smoking device along its length direction. It is conceivable that the light guide layer extends in several sections, wherein the sections do not touch each other. It is also conceivable that the light guide layer extends in one piece. It is possible that the light guide layer extends up to 100% of the length of the electrical smoking device along the length direction. In this case the whole outer surface of the housing comprises a display, wherein a width of the display extends of over ≥ 10 %, preferably ≥ 20 %, more preferably ≥ 30 %, more preferably ≥ 40 %, most preferably ≥ 50 % of a width of the electrical smoking device along its width direction.

According to another embodiment, the housing for an electrical smoking device is characterized in that the multilayer optoelectronic element is touch sensitive and provides means for giving a signal after being touched.

Preferably, the multilayer optoelectronic element comprises a touch screen for input of information of the electrical smoking device. Preferably, the touch screen is layered on a display, which is also comprised in the multilayer optoelectronic element as an information output of the electrical smoking device. Also preferably, the input and output information are signals for further processing. It is conceivable that the electrical smoking device comprises an information processing system, which can process the signals, preferably the input information, by touching the touch screen with a special stylus and/or fingers.

The objective is also reached by a method for manufacturing a housing for an electrical smoking device characterized by :
- providing a flexible printed circuit board,
- arranging a light emitting diode and a capacitive sensor on a surface of flexible printed circuit board,
- providing a light guide layer,
- arranging the on light guide layer the light emitting diode carrying side of the flexible printed circuit board,
- providing a cover material,
- arranging the cover material as a layer on the light guide layer opposite to the flexible printed circuit board, wherein the cover material is at least in some areas an outer wall of the electrical smoking device.

Preferably, the method for manufacturing the housing for an electrical smoking device can be linked to the already existing method for manufacturing the same housing. Existing machines could be used to manufacture some parts. It is conceivable, that arranging of a spacer and/or adhesive layer is needed.

Further advantages, objectives and features of the present invention will be described, by way of example only, in the following description with reference to the appended figures. In the figures, like components in different embodiments can exhibit the same reference symbols.

The figures show:
- Fig. 1a: a schematic side view of a housing 8 for an electrical smoking device 7;
- Fig. 1b: a schematic side view of a housing 8 for an electrical smoking device 7 with display 2;
- Fig. 2: a sectional view of an electrical smoking device 7;
- Fig. 3: a flow chart of a method for manufacturing a housing 8 with an optoelectronic element 9;
- Fig. 4: a schematic side view of a flexible printed circuit board 1.

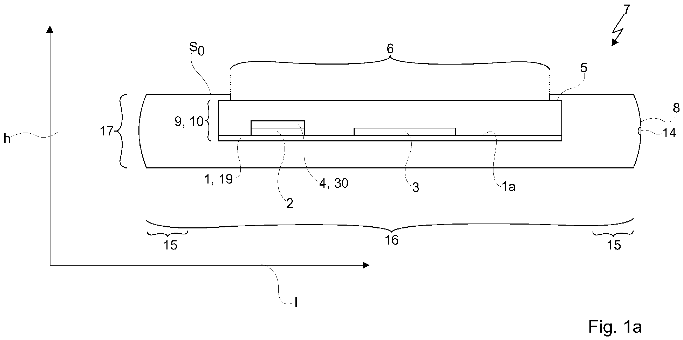

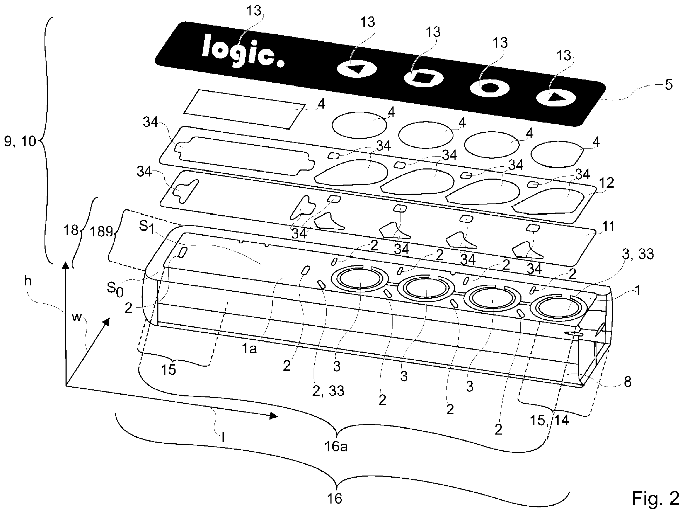

Figure 1a shows a schematic side view of a housing 8 for an electrical smoking device 7. The housing 8 is cylindrically shaped, wherein its length 16 extends along a length direction I and its height 17 extends along a height direction h. The housing 8 comprises a multilayer optoelectronic element 9 with at least three layers 10: a flexible printed circuit board 1 as a basic layer 19, a light guide layer 4 as a surrounded layer 30 and a cover layer 5. It is conceivable that the optoelectronic element 9 comprises further layer 10. It is possible that a spacer 11 and an adhesive layer 12 (shown in fig. 2) are comprised in the multilayer optoelectronic element 9.

The flexible printed circuit board 1 comprises at least one light emitting diode (LED) 2 and at least one capacitive sensor 3. Preferably, the light guide layer 4 coats the LED 2 and the cover layer 5 coats an LED 2 carrying surface 1a of the flexible printed circuit board 1. Also preferably, the LED 2 carrying side 1a of the flexible printed circuit board 1 also carries the capacitive sensor 3. The cover layer 5 is an outer surface 6 of the electric smoking device 7. Preferably, the cover layer 5 extends over 65 % of the length 16 of the electrical smoking device 7. It is possible that the cover layer 5 extends more or less than 65 % of the length 16 of the electrical smoking device 7. Preferably the cover layer 5 comprises graphics 13 (shown in fig. 2), wherein the LED 2 indirectly illuminates the graphics 13 due to the light guide layer 4.

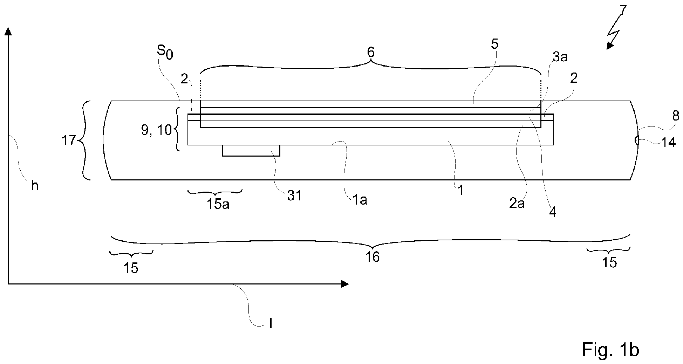

Figure 1b shows a schematic side view of a housing 8 for an electrical smoking device 7 with display 2a. The housing 8 is shaped identically to the housing 8 shown in figure 1a. The shown housing 8 comprises the multilayer optoelectronic element 9 with a display 2a and a touch screen 3a. Preferably, the flexible printed circuit board 1 is a first layer 10 of the multilayer optoelectronic element 9 along the height direction h. The flexible printed circuit board 1 comprises a carrying side 1a, on which the display and two LEDs 2 are mounted. The LEDs are preferably arranged at the end portions 15a of the optoelectronic element 9 with the display 2a and the light guide layer 4 between the LEDs 2. Preferably, the display 2a and the LEDs 2 form together the second layer 10 of the optoelectronic element 9. On the display 2a is a light guide layer 4 as a third layer 10 arranged, wherein the length (not shown here) of the light guide layer 4 is preferably identical to the length (not shown here) of the display 2a. As a fourth layer 10 of the multilayer optoelectronic element 9, the touch screen 3a is arranged. Preferably, the touch screen 3a and the light guide layer 4 are clear, wherein the light guide layer 4 is illuminated laterally by LEDs 2. As a last layer 10, preferably topmost layer, of the multilayer optoelectronic element 9 is a cover layer 5 arranged being an area 6 of an outer surface s0 of the electrical smoking device 7. Preferably, the multilayer optoelectronic element 9 extends over 60 % of the length 16 of the electrical smoking device 7.

It is conceivable that the optoelectronic element 9 is curved (not shown here), if the housing 8 of the electrical smoking device 7 is cylindrically shaped. In this case, all layers 10 of the optoelectronic element 9 are also cylindrically or as a segment of a hollow cylinder shaped. The cover layer 5 extends preferably with the curvature of the outer surface s0 of the housing 8. It is also conceivable that the shape of the housing 8 is a cuboid (not shown here). In this case it is possible that all the layers 10 of the optoelectronic element 9 are bent and run around a corner, wherein the layers 10 form an angle (not shown here). The housing 8 of the electrical smoking device 7 comprises two end portions 15, wherein one of the end portions 15 comprise a mouthpiece 14. The mouthpiece 14 is preferably designed as an output hole 32, wherein a user can suck on the mouthpiece 14 and start the smoking experience.

Figure 2 shows a sectional view of an electrical smoking device 7. The shown electrical smoking device 7 comprises following layers 10 in the following order along the height direction h: a housing 8 comprising a flexible printed circuit board 1, an adhesive layer 12, a spacer layer 11, several parallel light guide layer pieces 4 and a cover layer 5. A width 18 of the housing 18 of the electrical smoking device 7 extends along a width direction w, its height 17 extends along the height direction h and its length 16 extends along a length direction I. The electrical smoking device 7 further comprises two end portions 15, wherein a mouthpiece 14 is arranged at one of the end portions 15.

The flexible printed circuit board 1 comprises preferably several electrical and/or electronic components 33. Such components 33 are for example light emitting diodes 2 or capacitive sensors 3. The shown flexible printed circuit board 1 comprises capacitive sensors 3 and light emitting diodes 2, which are mounted along its length 16a on a carrying side 1a and emit light parallel to the length direction I. Subsequently, the adhesive 12 is arranged on a surface s1 of the printed circuit board 1. Preferably, the adhesive 12 is transparent, wherein the mounted electrical and/or electronic components 33 are surrounded with the adhesive 12. Preferably, the adhesive 12 is a layer, but it is also conceivable that is applied on the surface s1 of the flexible printed circuit board 1 as dots or lines. The spacer 11 is arranged along the height direction h after the adhesive 12 layer. The spacer 11 is preferably used to maintain a distance (not shown) between the flexible printed circuit board 1 and cover layer 5, especially on the portions of the surface s1, where no light guide layer 4 is attached. Preferably, the spacer 11 is colored, wherein the choice of color and/or pattern depends on a desired illuminated background (not shown) for a graphics 13. The spacer 11 and/or the light guide layer 4 further comprise recesses 34, in which the light guide layer 4 portions are arranged. Finally, the cover layer 5 is arranged on the spacer 11 and the light guide layer 4 portions. Preferably, the cover layer 5 is preferably clear and break and/or scratch resistant. Preferably, the cover layer 5 extends along the length I and width w direction, wherein a length and width of the cover layer is identical to the length 16a and width 18a of the surface s1 on the flexible printed circuit board 1 (not shown).

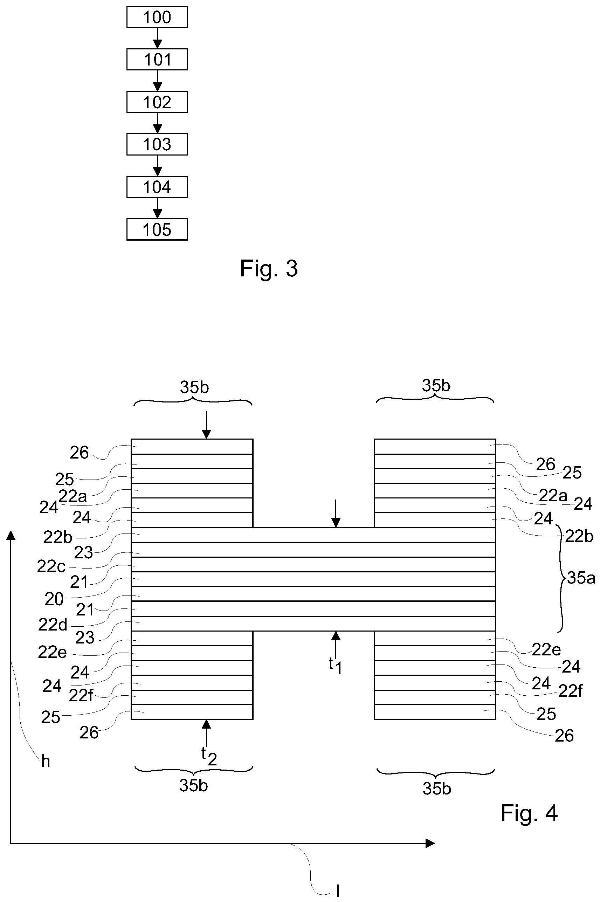

Figure 3 shows a flow chart of a method for manufacturing a housing 8 with an optoelectronic element 9. As a first manufacturing step a flexible printed circuit board 1 is provided 100 for further manufacturing. Subsequently as a second manufacturing step, at least one light emitting diode 2 and at least one capacitive sensor 3 are arranged 101 on a surface s1 of the printed circuit board 1. It is possible, that several electrical and /or electronic components 33 are arranged on the surface s1 during the second manufacturing step. As a third manufacturing step, a light guide layer 4 is provided 102. It is conceivable, that additionally a spacer layer 11 is provided. As a fourth manufacturing step, the light guide layer 4 is arranged 103 on the light emitting diode 2 carrying side 1a of the flexible printed circuit board 1. Preferably, the spacer layer 11 is also arranged on the light emitting diode 2 carrying side 1a of the flexible printed circuit board 1. It is conceivable, that between the surface s1 of the flexible printed circuit board 1 and the light guide layer 4 and/or the spacer layer 11, an adhesive layer 12 is arranged as a separate additional manufacturing step. As the fifth manufacturing step, a cover material 5 is provided 104. As a last manufacturing step, the cover material 5 is arranged on the previous layers 10 of the optoelectronic element 9. Preferably, the cover material 5 is arranged on the clear adhesive layer 12. Also preferably, the cover material 5 is arranged as a layer on the light guide layer 4 opposite to the flexible printed circuit board 1, wherein the cover material 5 is at least in some areas 6 (shown in fig. 1b) an outer wall s0 of the electrical smoking device 7.

Figure 4 shows a schematic side view of a flexible printed circuit board 1, which is comprised in an electrical smoking device 7. The flexible printed circuit board 1 comprises a flexible core stack 35a and at least one rigidized zone 35b, which is arranged on the flexible core 35a. Preferably, the flexible core stack 35a comprises the following layers along a height direction h: a polyimide core 23, a conductive layer 4 comprising copper 22d, an adhesive 21, a coverlay 20, an adhesive 21, a conductive layer 3 comprising copper 22c and a polyimide core 23. Preferably, the conductive layers 22c, d are formed as a conductive pattern. Also preferably, a thickness t1 of the flexible core stack 35a is 161 µm. It is conceivable that the flexible core stack 35a comprises additional layers.

The flexible printed circuit board 1 shown in figure 4 comprises four rigidized zones 35b, wherein two of the rigidizing zones 35b are arranged on each polyimide core 23 of the flexible core stack 35a. It is conceivable, that the flexible printed circuit board 1 comprises less or more rigidizing zones 35b on the common flexible core stack 35a. Each of the rigidizing zones 35b comprises a conductive layer comprising copper 22b, e, two no flow layers 24, preferably pre-preg 1080 glass, a further conductive layer comprising copper 22a, f, a plated copper layer 25 and a soldermask 26. It is conceivable, that the number of layers in the rigidized zone 35b of the flexible printed circuit board 1 varies. It is also conceivable, that each rigidized zone 35b comprises different number of layers. The total thickness t2 of two opposite rigidizing zones 35b and the flexible core stack 35a is preferably in range of 480 and 620 µm. It is possible, that the total thickness t2 varies depending on number of the layers in the rigidized zoned 35b and flexible core stack 35a.

The applicant reserves his right to claim all features disclosed in the application document as being an essential feature of the invention, as long as they are new, individually or in combination, in view of the prior art. Furthermore, it is noted that in the figures features are described, which can be advantageous individually. Someone skilled in the art will directly recognize that a specific feature being disclosed in a figure can be advantageous also without the adoption of further features from this figure. Furthermore, someone skilled in the art will recognize that advantages can evolve from a combination of diverse features being disclosed in one or various figures.

### List of reference symbols

- 1: flexible printed circuit board
- 1a: carrying side
- 2: light emitting diode (LED)
- 2a: display
- 3: capacitive sensor
- 3a: touch screen
- 4: light guide layer
- 5: cover layer
- 6: areas on the outer surface
- 7: electrical smoking device
- 8: housing
- 9: optoelectronic element
- 10: layers of the multilayer optoelectronic element
- 11: spacer
- 12: adhesive
- 13: graphics
- 14: mouthpiece
- 15: end portion of the electronic smoking device
- 15a: end portion of the optoelectronic element
- 16: length of the housing
- 16a: length of the flexible printed circuit board
- 17: height of the housing
- 18: width of the housing
- 18a: width of the flexible printed circuit board
- 19: basic layer of the optoelectronic element
- 20: coverlay
- 21: adhesive
- 22a: layer 1
- 22b: layer 2
- 22c: layer 3
- 22d: layer 4
- 22e: layer 5
- 22f: layer 6
- 23: polyimide core
- 24: pre-preg 1080 glass
- 25: plated copper
- 26: soldermask
- 30: surrounded layer
- 31: information processing system
- 32: output hole
- 33: electrical and/or electronic components
- 34: recess
- 35a: flexible core stack
- 35b: rigidized zone
- 100: providing a flexible printed circuit board
- 101: arranging a light emitting diode and a capacitive sensor
- 102: providing a light guide layer
- 103: arranging the on light guide layer the light emitting diode carrying side of the flexible printed circuit board
- 104: providing a cover material
- 105: arranging the cover material
- h: height direction
- I: length direction
- t1: thickness of the flexible core stack
- t2: total thickness of the flexible core stack and two rigidized zones
- w: width direction
- s1: surface of the flexible printed circuit board
- so: outer surface of the electrical smoking device

## Claims

1. A housing (8) for an electrical smoking device (7) comprising a multilayer optoelectronic element (9), comprising the following layers (10) in the following order along the height direction (h) of the multilayer optoelectronic element (9):
a flexible printed circuit board (1), having at least a light emitting diode (2) and a capacitive sensor (3) arranged on its surface (s1),
a light guide layer (4), arranged on the light emitting diode (2) carrying side (1a) of the flexible printed circuit board (1), and
a cover layer (5), arranged on the light guide layer (4) opposite to the flexible printed circuit board (1),
**characterized in that**
the cover layer (5) is at least in some areas (6) an outer surface (so) of the electrical smoking device (7).

2. The housing (8) for an electrical smoking device (7) according to claim 1,
**characterized in that**
the total high of the multilayer optoelectronic element is ≤ 2 mm, preferably ≤ 1.7 mm, more preferably ≤ 1.5 mm, most preferably ≤ 1.3 mm.

3. The housing (8) for an electrical smoking device (7) according to claim 1 or 2,
**characterized in that**
the light emitting diode (2) is extending from the surface (s1) of a carrier layer of the flexible printed circuit board (1) in the height direction (h), wherein the light emitting diode (2) is preferably a side firing diode, emitting light in a direction perpendicular to the height direction (h), wherein the side firing diode is preferably arranged in a recess (34) of the light guide layer (4).

4. The housing (8) for an electrical smoking device (7) according to any preceding claim,
**characterized in that**
the flexible printed circuit board (1) comprises a multilayer core (35a) comprising at least one polymer layer, and conductive circuit pattern affixed thereto, wherein the multilayer core preferably comprises ≥ 3, preferably ≥ 4, more preferably ≥ 5, most preferably ≥ 7 layer, from which an inner layer preferably comprises a Polyimide.

5. The housing (8) for an electrical smoking device (7) according to any preceding claim,
**characterized in that**
a height of the flexible printed circuit board (1) is ≤ 1 mm, preferably ≤ 0.5 mm, more preferably ≤ 0.25 mm, most preferably ≤ 0.15 mm.

6. The housing (8) for an electrical smoking device (7) according to any preceding claim,
**characterized in that**
the light guide layer (4) comprises a polymer, preferably a polyacrylate.

7. The housing (8) for an electrical smoking device (7) according to any preceding claim,
**characterized in that**
the light guide layer (4) comprises a recess (34) into which an electric component (33) mounted on the flexible printed circuit board (1) extends.

8. The housing (8) for an electrical smoking device (7) according to any preceding claim,
**characterized in that**
a height of the light guide layer (4) is ≥ 0.1 and ≤ 1 mm, preferably ≥ 0.2 and ≤ 0.8 mm, more preferably ≥ 0.3 and ≤ 0.7 mm, most preferably ≥ 0.4 and ≤ 0.6 mm.

9. The housing (8) for an electrical smoking device (7) according to any preceding claim,
**characterized in that**
the cover layer (5) comprises a glass, preferably a tempered glass, wherein the cover layer (5) provides means for detecting a changing capacity, preferably by means comprising a conductive layer within the cover layer (5).

10. The housing (8) for an electrical smoking device (7) according to any preceding claim,
**characterized in that**
a height of the cover layer is ≥ 0.1 and ≤ 1 mm, preferably ≥ 0.2 and ≤ 0.8 mm, more preferably ≥ 0.3 and ≤ 0.7 mm, most preferably ≥ 0.4 and ≤ 0.6 mm.

11. The housing (8) for an electrical smoking device (7) according to any preceding claim,
**characterized in that**
the cover layer (5) has
a Young's Modulus of ≥ 60 and ≤ 90 GPa, preferably ≥ 70 and ≤ 80 GPa, more preferably ≥ 72 and ≤ 78 GPa, most preferably ≥ 74 and ≤ 76 GPa and/or
a shear modulus of ≥ 10 and ≤ 50 GPa, preferably ≥ 20 and ≤ 40 GPa, more preferably ≥ 25 and ≤ 35 GPa, most preferably ≥ 28 and ≤ 32 GPa.

12. The housing (8) for an electrical smoking device (7) according to any preceding claim,
**characterized in that**
the electrical smoking device (7) comprises a mouthpiece (14) arranged in an end portion (15) of the electrical smoking device (7) along its length direction (I), wherein the height of the multilayer optoelectronic element (9) extends perpendicular with respect to the length direction (I) of the electrical smoking device (1).

13. The housing (8) for an electrical smoking device (7) according to any preceding claim,
**characterized in that**
the electrical smoking device (1) comprises a mouthpiece (14) arranged in an end portion (15) of the electrical smoking device (1) along its length direction (I), wherein the light guide layer (4) extends over ≥ 10 %, preferably ≥ 20 %, more preferably ≥ 30 %, more preferably ≥ 40 %, most preferably ≥ 50 % of the length of the electrical smoking device (1) along its length direction (I).

14. The housing (8) for an electrical smoking device (7) according to any preceding claim,
**characterized in that**
the multilayer optoelectronic element (9) is touch sensitive and provides means for giving a signal after being touched.

15. Method for manufacturing a housing (8) for an electrical smoking device(7), preferably according to any preceding claim,
**characterized by**
- providing a flexible printed circuit board (1),
- arranging a light emitting diode (2) and a capacitive sensor (3) on a surface (s1) of flexible printed circuit board (1),
- providing a light guide layer (4),
- arranged the on light guide layer (4) the light emitting diode (2) carrying side of the flexible printed circuit board (1),
- providing a cover material (5),
- arranging the cover material (5) as a layer on the light guide layer (4) opposite to the flexible printed circuit board (1), wherein the cover material (5) is at least in some areas (6) an outer wall (s0) of the electrical smoking device (7).
